# EUROPEAN PATENT APPLICATION

(11) **EP 4 822 994 A1**
(43) Date of publication of application: **14.10.2026**
(21) Application number: 25169089.7
(22) Date of filing: 08.04.2025
(51) Int. Cl.: H03M 3/00

(54) **MULTI-RATE SIGMA-DELTA ADC**

(71) Applicant: Semtech Corporation, Camarillo CA 93012-8790 (US)
(72) Inventor: Vandel, Eric, 1426 Concise (CH); Heragu Singaiyengar, Aravind Prasad, 1020 Renens (CH)
(74) Representative: P&TS SA (AG, Ltd.)

(57) **Abstract**

A sigma-delta ADC for processing an analog input signal and generating a sampled digital representation of the input signal, comprising: a continuous-time subcircuit comprising an input integrator receiving the analog input signal and generating a first signal, a fast discrete-time subcircuit operating at a first clock rate receiving the first signal and generating a second signal, a slow discrete-time subcircuit operating according to a second clock rate slower than the first clock rate, the slow discrete-time subcircuit comprising a quantizer transforming the second signal into a digital signal and a DAC generating an analog feedback signal.

## Description

### Technical field

The present invention relates to the field of mixed analog and digital electronic circuits, particularly to a low-power architecture for converting analog signals into a digital representation that uses a sigma-delta modulator.

### Background

Many electronics applications involve converting analog signals into a time series of digital samples. Digital signal processing techniques and architectures can often provide better results at a lower cost, or consuming less power and silicon surface, than their analogue counterparts. A circuit especially configured to accept an analog signal as input and produce a corresponding digital output signal is known as an analog-to-digital converter (ADC). ADCs are used in countless electronic circuits and applications.

An important use case of ADCs is in radio receivers, where they contribute to the overall performance, sensitivity, and power consumption. ADC are generally used in signal recording and processing, including audio and video signals, and are essential to most measurement techniques.

Sigma-delta ADCs achieve this result by applying sigma-delta modulation to the input signal. This is an oversampling process that encodes the input signal into a low-bit digital signal (possibly a 1-bit signal) at a sample-frequency much higher than the Nyquist rate. Oversampling increases the signal-noise ratio. Sigma-delta converters use noise shaping techniques that shift the spectral distribution of the quantization noise to higher frequencies, out of the spectral region of interest. These methods lead to an even higher signal-noise ratio. The sigma-delta modulated signal can be used and processed as is or converted into a lower rate code-modulated signal by known techniques of digital signal processing, such as decimation and filtering.

It is known to use continuous-time (CT) and discrete-time (DT) structures, the latter generally using switched-capacitor circuits, in sigma-delta converters and modulators.

EP 3104530 B1 and WO 2023/225655 A1 disclose two examples of sigma-delta digital modulators and converters.

### Overview

An aim of the present invention is the provision of a sigma-delta ADC that combines the advantages of continuous-time sigma-delta modulators with those of discrete-time implementations, providing an inherent anti-aliasing filter and that overcoming other shortcomings and limitations of the state of the art.

According to the invention, these aims are attained by the object of the attached claims, and especially by a sigma-delta ADC for processing an analog input signal and generating a sampled digital representation of the input signal, comprising: a continuous-time subcircuit comprising an input integrator receiving the analog input signal and generating a first signal, a fast discrete-time subcircuit operating at a first clock rate receiving the first signal and generating a second signal, a slow discrete-time subcircuit operating according to a second clock rate slower than the first clock rate, the slow discrete-time subcircuit comprising a quantizer transforming the second signal into a digital signal and a DAC generating an analog feedback signal.

Preferably the fast discrete time subcircuit comprises at least one integrator and switched capacitor blocks clocked at the first clock rate. One of the switched capacitor blocks samples and hold a signal that is provided to the integrator, which thus operates in discrete time at the fast clock rate. The combination of a first continuous-time input integrator followed by a discrete-time integrator yields a second-order sigma-delta modulator, but this is not a limitation of the invention, with admits also higher-order realizations.

The ADC of the invention may have a CRFB (cascade of resonators in feedback) configuration, a CIFF (cascade of integrators with feed-forward) configuration or any other suitable topology.

Preferably, the second clock rate is derived from the first clock rate or inversely, such that a between second clock rate and the first clock rate is fixed and determined. The slow clock may result from an integer or fractional division of the fast clock. In typical examples, the fast clock has a frequency of 32 MHz, and the slow clock is obtained from by dividing (scaling) the fast clock by a factor of 2, 4, 8, or more.

The sigma-delta ADC of any one of the preceding claims, wherein the fast discrete-time subcircuit comprises and the slow discrete-time subcircuit comprises switched capacitor blocks clocked at the second clock rate.

The inventive ADC may be configured to process single-ended or differential input signals. In the latter case, the relevant analogue signals are preferably differential in nature. This may include the first signal, generated by the first integrating stage, and the second signal that is given to the quantizer.

The ADC of the invention lends itself to countless applications, among which, a digital radio receiver comprising an antenna, a mixer converting a radio signal into a lower frequency signal, the AD followed by a decimation circuit and by a digital demodulator.

With respect to what is known in the art, the invention provides an advantageous reduction in power consumption and complexity, together with inherent anti-aliasing properties. The digital circuits that follow the ADC operate at a reduced rate, since the ADC output is clocked by the slower clock; hence, their power needs and complexity are reduced as well. Another advantage is that the ADC can be easily reconfigured-for example changing the fast clock frequency and/or a scaling ratio between the fast clock and the slow one-according to the need.

### Summary of the drawings

Exemplar embodiments of the invention are disclosed in the description and illustrated by the drawings in which:
Figure 1 illustrates schematically an example of ADC according to the invention with a CRFB (cascade of resonators in feedback) topology
Figure 2 is a simplified schematics of an ADC according to the invention with a CIFF (cascade of integrators with feed forward) topology.
Figure 3 shows the inventive ADC used in a digital radio receiver.
Figure 4 illustrates schematically a differential implementation of a CRFB ADC of the invention.

Remarkable element in the drawings are identified by reference signs that are referred to in the following written description. Identical, similar or functionally equivalent elements may be identified by the same reference sign. When a figure contains several identical, similar or functionally equivalent elements, some reference signs may be omitted for legibility's sake.

### Examples of embodiments of the present invention

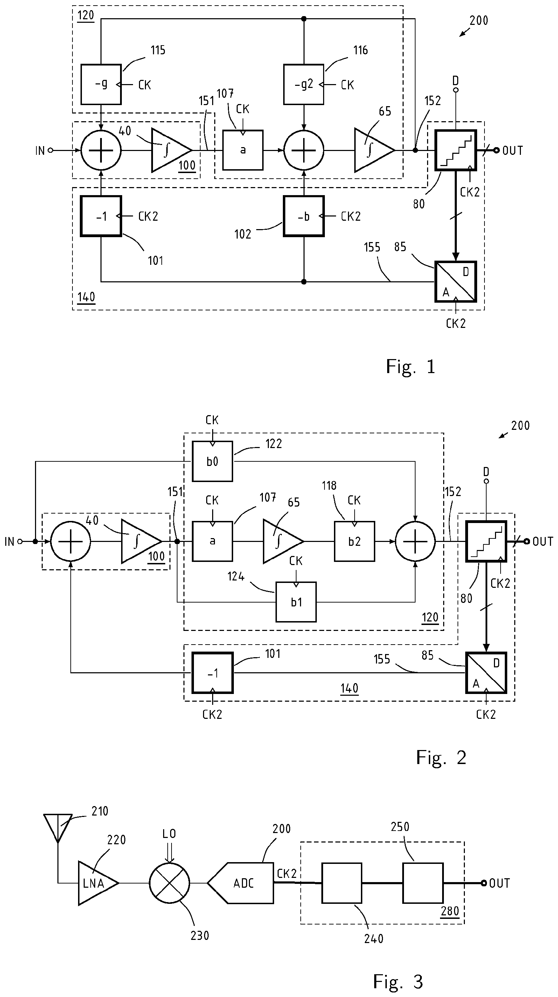

**Figure 1** shows an example of sigma-delta ADC 200 according to the invention having a second order CRFB topology. The invention is not limited to this special realization and may be extended to higher orders and to other types of sigma/delta topologies, for example CIFF, CIFB (cascaded integrators in feedback) and so on. The input stage **100** of the ADC is an integrator operating in continuous time, comprising the integrating stage **40.** This configuration inherently provides a useful filtering of the input signal.

The signal **151** generated by the first integrator is given to a discrete-time subcircuit **120** that is synchronised by a clock **CK** whose frequency will be determined by the application's requirement. It may be 32 MHz, for example. The clock **CK** will be referred to in this disclosure as the "fast" clock, relative to the "slow" clock **CK2** that will be introduced later. The "first" and "second" labels will be also used to designate the clocks **CK, CK2.**

In the fast subcircuit 120, a second integrator **65** of the ADC operates in discrete time according to the fast clock **CK** applied to the switched capacitor block **107.** Unit **107** introduces a scale factor "a" to the signal applied to the second integrating stage **65.**

ADC **200** comprises also two more switched capacitor blocks **115** and **116** operating at the same rate as the capacitor block **107** and preferably clocked by the same clock signal. They feed the output of the second integrator back to the sum nodes before the first, respectively second integrator. The scale factors -*g* and -*g*₂ introduced by the switched capacitors blocks contribute to the definition of the signal transfer function and noise transfer function of the ADC, especially of its zeros, as it will be explained below. The values of these also depends on the required in-band noise suppression for a given decimation ratio.

The output of the second integrator is applied to a quantizer **80** that, importantly, operates in discrete time at a slow clock **CK2** characterised by a frequency lower than that of the fast clock **CK.** The second clock signal **CK2** may be obtained from the first one by a simple integer division, or by a fractional division. The clock frequency CK2 of the quantizer can be modified, based on the signal bandwidth and dynamics required by the target application.

The quantizer **80** may have, for example, a successive approximation architecture (SAR) and a bit depth of 8 to 11 bits, but these are not essential requirements to the invention. Preferably, to improve system linearity, the quantizer **80** has preferably a second auxiliary input to accept a dithering code **D** that is added to the quantizer input at the reduced rate **CK2.** The dithering code is a pseudorandom code with the same bit width as the quantizer output. Its purpose is to improve the ADC linearity by exercising different sections of the ADC

The digital signal generated by the quantizer is also converted back into analog feedback signal **155** by the DAC unit **85,** that operates also in discrete time with the same reduced clock **CK2** as the quantizer **80.** The resulting analog signal is also fed back to the input of the first and second integrator by two switched capacitor blocks **101** and **102** that are also clocked by the reduced clock **CK2.** These blocks introduce a scale factor of -*b*, respectively -1. These factors enter in the definition of the noise and signal transfer functions, as it will be discussed later. The invention is not limited to this choice of coefficients, and the factor associated to block **102** may differ from -1, if desired.

Remarkably, the scaling factors *g*, *g*₂, *b*, 1 are implemented by switched capacitor blocks **115, 116, 102, 101** and the gain of the integrating amplifiers **40, 65** is also determined by the capacitances of their respective feedback networks (not shown in this drawing). Therefore, the transfer function of the inventive ADC is determined mainly by ratios of capacitances, which are largely insensitive to process variations. Hence, the ADC of the invention require less or no calibration / trimming operations to operate in the intended specifications. Preferably, the DAC **85** is also implemented using capacitors (it is a capacitive DAC or CDAC) for the same purpose.

It is important to note that the device of the invention has different blocks operating at different rates. The figure identifies a continuous time subcircuit **100,** a fast discrete-time subcircuit **120** synchronised to the fast clock signal **CK,** and a slow discrete-time subcircuit **140** synchronised to the slow clock signal **CK2.** The continuous-time input stage **100** provides inherently an anti-aliasing filter as in continuous-time delta-sigma modulators. Further, the second integrator works at much higher rate than the quantizer and the feedback DAC **85,** and this oversampling also contributes to reduce aliasing of out-of-band signal components. Further, the anti-aliasing property is well maintained as the first integrator operates in continuous time, and the second one at a higher clock frequency than the quantizer.

The noise transfer function of the proposed device can be analysed assuming that the second integrator, working at higher rate than the quantizer, can be considered as a continuous-time integrator with respect to the quantization noise. The noise transfer function (NTF) can be shown to be given by $NTF \left(z\right) = \frac{{z}^{- 2} - \left(2+{g}_{2}-ag\right) {z}^{- 1} + \left(1+{g}_{2}\right)}{\left(a-b+1\right) {z}^{- 2} + \left(b-{g}_{2}-2+ag\right) {z}^{- 1} + \left(1+{g}_{2}\right)}$ where z corresponds to the decimated sampling rate CK2.

Applying the relation *z = e^{sT}* between the Laplace transformation (*s* domain) and the z transformation, the signal transfer function (STF) can be written as $\begin{matrix}STF \left(s, z\right) \\ = \frac{a \left({z}^{- 2}-\left({g}_{2}-ag+2\right){z}^{- 1}+\left(1+{g}_{2}\right)\right)}{\left(ag+{sT}_{s}\left.\left({g}_{2}+m ln\left({z}_{1}\right)\right)\right)\left({z}^{- 2}\left(a-b+1\right)\right.+{z}^{- 1}\left(b+ag-2-{g}_{2}\right)+\left(1+{g}_{2}\right)\right)}\end{matrix}$ where *z*₁ corresponds to the full sampling rate **CK** of the fast discrete-time subcircuit **120.** It should be noted that, if the slow clock **CK2** is derived from the fast one with an integer division by a quotient *N,* then $z = {z}_{1}^{N}$.

The STF is expressed in term of both a continuous time variable *s* corresponding to the contribution of the continuous-time subcircuit **100,** a discrete variable *z*₁ for the contribution of the second integrator, and a discrete variable z for the slow discrete-time subcircuit **140.** This is inherent to the novel feature of this device has a reaction loop working at different rates.

As mentioned, the invention is not limited to a CRFB architecture. **Figure 2** shows a CIFF (cascaded integrators with feed-forward) implementation of the invention. The input stage **100** is a time-continuous integrator as that of the previous example, but the desired NTF and STF are synthesized using feed-forward loops. The fast discrete-time subcircuit **120** includes, in this example, a second discrete-time integrator realized with the switched capacitor block **107** and the integrator **65.** The output of this is combined the input signal, through block **122** and with the once-integrated signal, through block **124,** before being presented to the quantizer **80,** which operates at the reduced clock rate **CK2,** like SDAC **85** and switched capacitor block **101,** in the slow discrete-time subcircuit **140.** As the previous example, this embodiment has two integration stages; however, the invention admits also higher order realizations.

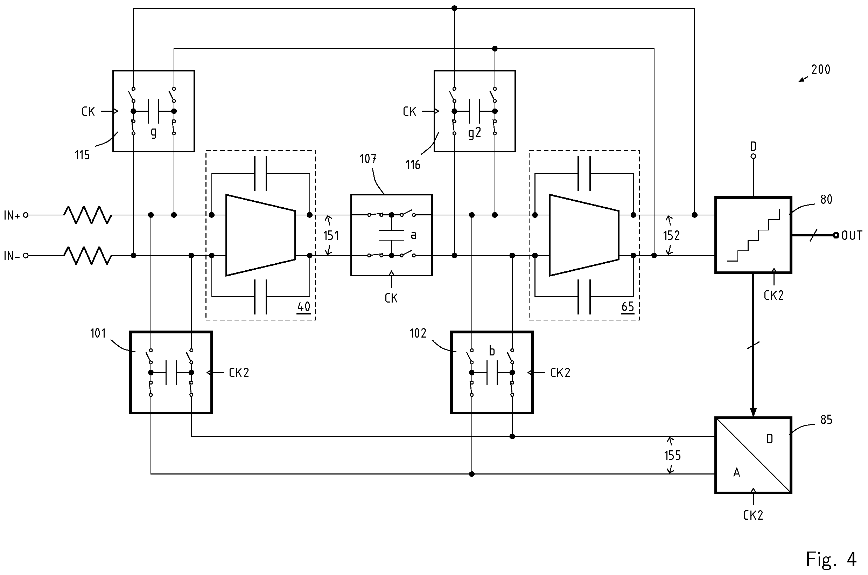

**Figure 4** is another schematic representation of a CRFB ADC according to the invention that shows a differential architecture. The integrating amplifiers **40, 65** are implemented by full-differential operational amplifiers with feedback capacitors, the switched capacitor blocks **101, 102, 115, 116, 107** are also drawn with an example of internal circuit. Other ways of implementing these functions are available, however.

**Figure 3** shows a possible use of the inventive ADC **200** in a radio receiver. The radio signal received by antenna **210** and amplified by low-noise amplifier **220** is converted to a lower frequency signal in the mixer **230** and digitised by ADC **200.** Advantageously, the ADC 200 implements analog anti-aliasing inherently. Its output is given to a digital receiver stage **280** where the samples from the ADC **200** may be decimated and/or filtered digitally, in block **240,** and demodulated. Since the output of the ADC **200** is already clocked at a rate **CK2** considerably lower than the inner rate **CK,** the power consumption of the digital block **280** is significantly reduced.

### reference symbols in the figures

- 40: integrator
- 65: integrator
- 80: quantizer
- 85: CDAC
- 100: continuous time subcircuit
- 101: switched capacitor block
- 102: switched capacitor block
- 107: switched capacitor block
- 115: switched capacitor block
- 116: switched capacitor block
- 118: switched capacitor block
- 120: fast discrete-time subcircuit
- 122: switched capacitor block
- 124: switched capacitor block
- 140: slow discrete-time subcircuit
- 151: first signal
- 152: second signal
- 155: 1feedback signal
- 200: ADC
- 210: antenna
- 220: low-noise amplifier
- 230: mixer
- 240: decimation filter
- 258: demodulation
- 280: digital reception unit

## Claims

1. A sigma-delta ADC (200) for processing an analog input signal (IN) and generating a sampled digital representation (OUT) of the input signal, comprising
- a continuous-time subcircuit (100) comprising an input integrator (40) receiving the analog input signal (IN) and generating a first signal (151)
- a fast discrete-time subcircuit (120) operating at a first clock rate (CK) receiving the first signal (151) and generating a second signal (152)
- a slow discrete-time subcircuit (140) operating according to a second clock rate (CK2) slower than the first clock rate (CK), the slow discrete-time subcircuit comprising
- a quantizer (80) transforming the second signal (152) into a digital signal (OUT)
- a DAC (85) generating an analog feedback signal (155) .

2. The sigma-delta ADC of the preceding claim, wherein the fast discrete-time subcircuit (120) comprises at least one integrator (65).

3. The sigma-delta ADC of any one of the preceding claims, in a CRFB configuration or in a CIFF configuration.

4. The sigma-delta ADC of any one of the preceding claims, the input signal (IN), the first signal (151) and the second signal (152) being differential signals.

5. The sigma-delta ADC of any one of the preceding claims, wherein the second clock rate (CK2) is derived from the first clock rate (CK) or inversely, such that a between second clock rate (CK2) and the first clock rate is fixed and determined.

6. The sigma-delta ADC of any one of the preceding claims, wherein the fast discrete-time subcircuit (120) comprises switched capacitor blocks clocked at the first clock rate and the slow discrete-time subcircuit (140) comprises switched capacitor blocks clocked at the second clock rate.

7. A digital radio receiver comprising an antenna, a mixer converting a radio signal into a lower frequency signal, an ADC according to any one of the preceding claims, a decimation circuit, and a digital demodulator.
